# EUROPÄISCHE PATENTSCHRIFT

(11) **EP 1 037 030 B1**
(45) Veröffentlichungstag und Bekanntmachung des Hinweises auf die Patenterteilung: **02.08.2006**
(21) Anmeldenummer: 00103567.4
(22) Anmeldetag: 19.02.2000
(51) Int. Cl.: G01M 15/00, G01M 17/02, G01M 13/02

(54) **Verfahren zum Simulieren des Verhaltens eines Fahrzeugs auf einer Fahrbahn**
Procedure for simulating the behaviour of a vehicle on a roadway
Procédé de simulation du comportement d'une voiture sur une chaussée

(30) Priorität: 12.03.1999 DE 19910967
(43) Veröffentlichungstag der Anmeldung: 20.09.2000
(73) Patentinhaber: AVL DEUTSCHLAND GMBH, 55252 Main-Kastel (DE); Dr.Ing. h.c.F. Porsche Aktiengesellschaft, 70435 Stuttgart (DE)
(72) Erfinder: Germann, Stefan, 64653 Lorsch (DE); Nonn, Harald, 69469 Weinheim (DE); Kopecky, Wolfgang, 68623 Lampertheim-H-ttenfeld (DE); Abler, Georg, 8010 Graz (AT); Witte, Lothar, 71665 Vaihingen (DE); Xuan, Hai Tran, 70825 Korntal-M-nchingen (DE); Pfeiffer, Michael, 75181 Pforzheim (DE); Brodbeck, Peter, 75223 Niefern--schelbronn (DE)
(74) Vertreter: Grünberg, Thomas

(56) Entgegenhaltungen:
- EP-A- 0 775 902
- DE-A- 3 812 824
- ZEGELAAR P W A ET AL: "TYRE MODELS FOR THE STUDY OF IN-PLANE DYNAMICS" VEHICLE SYSTEM DYNAMICS, SWETS AND ZEITLINGER, LISSE, NL, Bd. 23, 23. August 1993 (1993-08-23), Seiten 578-590, XP000605838 ISSN: 0042-3114

## Beschreibung

Die Erfindung betrifft ein Verfahren zum Simulieren des Verhaltens eines Fahrzeugs auf einer Fahrbahn auf einem Antriebsstrang-Prüfstand.

Neben den weiter unten abgehandelten Simulationsverfahren auf einem Antriebsstrang-Prüfstand sind aus der DE 43 25 413 C2 und DE 40 30 653 A1 mathematische Abschätzungsverfahren für direkt nicht meßbare, das reale Fahrverhalten charakterisierende Größen entnehmbar. Hierzu werden die meßtechnisch zugänglichen Sensorsignale mit Bewegungsgleichungen und unter Einbeziehung eines Reifenmodells so verarbeitet, daß sich die gewünschten Größen ergeben. Um zu einem Satz lösbarer Gleichungen für die gewünschten Größen zu gelangen, werden in der DE 43 25 413 C2 z.B. die Reifenkräfte und der Kraftschlußbeiwert als quasistationär behandelt. Als gemessene Sensorsignale werden in eine Recheneinheit Signale eingegeben, die die Fahrzeuglängsgeschwindigkeit, die Längs- und Querbeschleunigung, die Giergeschwindgigkeit, den Lenkwinkel und die Raddrehzahl der Räder repräsentieren. Um die Bestimmung von den Fahrzustand charakterisierender Größen in allen Fahrzuständen zu ermöglichen, werden gemäß der DE 43 25 413 C2 die Bewegungsgleichungen durch auf einem Fahrzeugmodell beruhende Meßgleichungen ergänzt, die mit den Bewegungsgleichungen so kombinierbar sind, daß der erforderliche Satz Lösungsgleichungen z.B. für den Schwimmwinkel gewonnen werden kann. Die Meßgleichungen werden aus einem Vierradmodell abgeleitet. Als Zustandsgröße wird der Neigungswinkel der Fahrbahn gegenüber der Ebene herangezogen. In der DE 40 30 653 A1 wird ein Abschätzungsverfahren für den Schräglaufwinkel der Räder oder der Achsen eines gebremsten Fahrzeugs sowie für die Seitenführungskräfte an den Rädern und die Reifenaufstandskräfte angegeben. Es wird ein vereinfachtes Fahrzeugmodell vorausgesetzt, das Nicken, Wanken und Hubbewegungen nicht berücksichtigt. Seitenführungskraft und Bremskraft werden aus dem HSRI-Reifenmodell berechnet. Als Meßgrößen werden die Radgeschwindigkeit, die Giergeschwindigkeit, der Hauptbremszylinderdruck und die Radbremsdrücke herangezogen.

Aus der DE 37 00 409 A1 ist ein Bewegungsabschätzsystem entnehmbar, das ein simuliertes Fahrzeug mit einem Satz Fahrzeugbewegungsgleichungen darstellt. Das System verwendet einen Sensor für die einem Rechner direkt zugeführte, gemessene Fahrzeuggeschwindigkeit und einen Sensor für den Lenkradwinkel, der einem Lenkmodell zugeführt wird. Der Rechner soll u.a. auch den Seitenschlupfwinkel abschätzen, ferner liefert er einem Rollmodell einen Querbeschleunigungswert. Das Rollmodell ermittelt hieraus einen Fahrzeugrollwinkel, der wiederum dem Rechner zugeführt wird. Der digitale Rechner ist mit analogen Rechenkreisen für das Lenkmodell und Rollmodell verbunden, die zur Simulation dieser Teile des herangezogenen Gesamtmodells dienen und dem digitalen Rechner den Vorderradlenkwinklel und den Rollwinkel für seine Abschätzungen zuführen. Mit Hilfe der gemessenen Fahrzeuggeschwindigkeit schätzt dann der digitale Rechner aus einem ebenen Bewegungsmodell die gewünschten Fahrzeugbewegungsvariablen ab. Eine Schlupfsimulation läßt sich hierdurch nicht realisieren.

Ferner werden Prüfstände zum Testen des Antriebsstrangs eines Fahrzeuges, in denen eine Simulation der Fahrwiderstände und des Beschleunigungsverhaltens des Fahrzeugs sowie der Fahrzeugräder mittels an den Antriebswellen des Fahrzeugs angebrachter elektrischer Belastungsmaschinen erfolgt, seit etlichen Jahren in der Automobilindustrie eingesetzt. Einen solchen Prüfstand beschreibt die EP 0 338 373 B1, wobei dort der Hauptantriebsstrang, die Achsgetriebe, die treibenden Wellen, die Kupplung, das Getriebe und der Verbrennungsmotor als vorhandene Komponenten mit ihrem realen Verhalten eingehen. Die Belastungsmaschinen sind drehmomentgeregelte Elektromotoren, denen von einem Rechner ein Drehmomentsollwert vorgegeben wird. Dieser Wert wird aus einer Drehzahldifferenz erzeugt, die auf einen Integrierer mit einer zur Federsteifigkeit des Reifens proportionalen Zeitkonstanten und ein parallelliegendes Proportionalglied mit einem zur Reifendämpfungskonstanten proportionalen Verstärkungsfaktor gegeben wird. Der Drehmomentsollwert wird aus der Summe der vom Integrierer und vom Proportionalglied gelieferten Feder- und Dämpfungsmomente gebildet. Die Drehzahldifferenz ergibt sich aus der gemessenen Winkelgeschwindigkeit bzw. Drehzahl der Antriebswelle an der elektrischen Belastungsmaschine und einer der Fahrzeuggeschwindigkeit proportionalen Winkelgeschwindigkeit. Letztere wird dadurch ermittelt, daß das um die Drehmomentsollwerte für die simulierten Räder verminderte Fahrwiderstandsmoment in einem Integrierer mit einer zum Fahrzeugträgheitsmoment proportionalen Zeitkonstanten integriert wird.

Die oben beschriebene Bildung des Drehmoments beruht somit auf einer Drehzahlregelung, die zwar die Federsteifigkeit und Dämpfung des Reifens in Betracht zieht, jedoch grundsätzlich den Reifenschlupf außer acht läßt. Um diese Unzulänglichkeit zu überwinden, ist es aus der EP 0 338 373 B1 ferner bekannt, zur Berücksichtigung eines kinematischen Reifenschlupfes von der der Fahrzeuggeschwindigkeit proportionalen Winkelgeschwindigkeit das Produkt aus dieser Winkelgeschwindigkeit und einem Schlupfwert zu subtrahieren, der als Funktion des Drehmomentsollwerts ermittelt wird, bevor der obige Drehzahlvergleich anhand der so modifizierten Winkelgeschwindigkeit erfolgt. Hinsichtlich dieser Berücksichtigung des kinematischen Schlupfes ist als nachteilig herausgestellt, daß die Momentenaufteilung im Antriebsstrang während des Schlupfens bekannt sein müßte, um die erwartete Momentenbilanz zur Errechnung des Drehzahlgradienten heranziehen zu können, daß aber gerade diese Momentenaufteilung insbesondere während dynamischer Vorgänge oder bei Systemen mit variabler Momentenverteilung (Durchdrehen) nicht bekannt sei. Ein durchdrehendes oder blockierendes Rad wird deshalb alternativ so simuliert, daß der Drehmomentsollwert auf ein entsprechendes konstantes Schlupfmoment begrenzt wird, das aus einem vorgebbaren fahrbahnrepräsentativen Reibwert, einer Radaufstandskraft und einem Reifenradius berechnet wird. Außer in den Bereichen des übertragenen Moments, in denen der Begrenzer den Drehzahlregler zur Simulation des Blockierverhaltens an seine Begrenzung laufen läßt, wird der Reifen schlupffrei simuliert.

Diese bekannte Art der Berücksichtigung des Reifenschlupfes stellt hinsichtlich der realitätsnahen Nachbildung des Reifens lediglich eine Kompromißlösung dar, so daß in den gegenwärtigen Antriebsstrangprüfständen in der Regel auf eine Reifensimulation verzichtet wird und nur solche Größen des Fahrzeugverhaltens geprüft werden, bei denen der Reifen bzw. Reifenschlupf vernachlässigt werden kann. Zur Vermeidung von unzulässigen Momentenverläufen wird am Prüfstand mit Hilfe von Momentenausgleichsreglern eine Momentenverteilung aufgeprägt, die nur den theoretischen Werten des Antriebsstrangs, nicht aber den realen Verläufen entspricht.

Ansonsten werden an den Prüfständen im übrigen Lastkollektive nachgefahren, deren Daten in Form der Drehzahl und des Drehmoments an den jeweils interessierenden Rädern auf einer repräsentativen Teststrecke konventionell an Fahrzeugen aufgenommen werden, die mit Einrichtungen zur Momenten- und Drehzahlmessung ausgestattet sind. Dann kann der Prüfling auf dem als Belastungsprüfstand betriebenen Prüfstand unter Nachfahren der auf der Strecke realitätsnah aufgenommenen Lastkollektive z.B. hinsichtlich seiner Dauerfestigkeit getestet werden. Auch in der Prüfeinrichtung der DE 38 18 661 A1 erfolgt die Nachbildung von zuvor gemessenen oder errechneten Lastkollektiven an einem Fahrzeugprüfstand. Dies Schrift läßt offen, welche Programme im Rechner der Prüfeinrichtung zugrunde gelegt werden, um die gewünschten Lastkollektive festzulegen und die Stellgrößen für die Stellglieder zu ermitteln. Es wird gemäß dieser Schrift ein Fahrzeugrad mittels Simulationsantrieb, Stellgliedern und Rechner simuliert, welcher keine aktuellen, während der Simulation anfallenden Meßgrößen berücksichtigt. Durch Erzeugung von Querkräften und Momenten an den Stellgliedern werden Aufstands- und Seitenkräfte simuliert, wobei die Simulation jedoch letztlich auf den vorgegebenen Lastkollektiven beruht.

Der Erfindung liegt die Aufgabe zugrunde, ein Verfahren anzugeben, das es gestattet, das Verhalten eines Fahrzeugs auf einer Fahrbahn an einem Antriebsstrang-Prüfstand mit die Räder nachbildenden elektrischen Belastungsmaschinen möglichst realitätsnah zu simulieren.

Diese Aufgabe wird durch den Gegenstand des Anspruchs 1 gelöst. Vorteilhafte Weiterbildungen sind in den Unteransprüchen definiert. Erfindungsgemäß wird eine Fahrzeuggeschwindigkeit in einem Fahrzeugmodell unter Rückführung der in einem Reifenmodell berechneten, auf die Fahrbahn übertragenen Kraft ermittelt und wiederum dem Reifenmodell zugeführt, um die im Anspruch 1 definierte Schlupfsimulation zu erzielen. Die auf die Fahrbahn übertragene Kraft und ein sich für diese Kraft ergebendes Solldrehmoment für die entsprechende momentengeregelte Belastungsmaschine werden hierzu im Reifenmodell wiederum aus der Fahrzeuggeschwindigkeit und einer Reifenaufstandskraft für eine gemessene Raddrehzahl derart bestimmt, daß sich zwischen einem nominellen, der Fahrzeuggeschwindigkeit entsprechenden Drehzahlwert und der gemessenen Raddrehzahl eine dem realen Schlupf entsprechende Differenz einregelt.

Das erfindungsgemäße Verfahren vermeidet im Gegensatz zum weiter oben aufgezeigten Stand der Technik (EP 0 338 373 B1) eine Drehzahlregelung zur Gewinnung eines der elektrischen Belastungsmaschine vorzugebenden Solldrehmoments. Statt dessen wird dieses mit Hilfe eines die schlupfabhängige Reibung eines Reifens nachbildenden Reifenmodells bestimmt. Insbesondere wird im erfindungsgemäßen Verfahren mit diesem Modell aus der an der Antriebswelle bzw. der elektrischen Maschine gemessenen Raddrehzahl eine Kraft ermittelt, die bei dieser Raddrehzahl unter Berücksichtigung eines im Realfall auftretenden bleibenden Schlupfes vom Reifen auf eine Fahrbahn übertragen wird. Hierzu werden als weitere Eingangsgrößen in das Reifenmodell eine jeweilige Reifenaufstandskraft und eine Fahrzeuggeschwindigkeit eingegeben.

Im Gegensatz zu der erläuterten bekannten Drehzahlregelung wird im erfindungsgemäßen Verfahren über das Reifenmodell eine sich auch im wahren Fahrbetrieb einstellende Abweichung zwischen einer nominellen fahrzeuggeschwindigkeitsproportionalen Raddrehzahl und der gemessenen Raddrehzahl eingeregelt. Hierdurch gelingt es, einen dem Realfall entsprechenden Fahrbetrieb zu simulieren. Hierbei gehen sowohl die Kontakteigenschaften des Reifens einschließlich des sich ändernden Anteils der Radlauffläche auf der Fahrbahn als auch die jeweilige Fahrsituation (Geradeausfahrt, Kurvenfahrt, unterschiedliche Fahrbahnneigungen und hieraus resultierende variable Radaufstandskräfte) ein. Die in das Reifenmodell eingegebenen Parameter können in die Formeln des jeweiligen Modells eingesetzt werden, um insbesondere die Schlupfabhängigkeit des Reibwerts für die jeweiligen Parameter nachzubilden. Der Verlauf der Reibwertkurven in Abhängigkeit des Schlupfes ist in den unterschiedlichen bekannten Reifenmodellen z.B. dem nach Pacejka, Böhm oder dem HSRI-Modell prinzipiell ähnlich und umfaßt ausgehend vom Schlupf Null einen steilen Anstieg bis zu einem maximalen Reibwert bei einem kritischen Schlupf mit darauf folgendem vergleichsweise mäßigem Abfall des Reibwerts, bis der Schlupf den Wert Eins annimmt.

Das erfindungsgemäße Verfahren ist nicht auf ein spezielles Reifenmodell beschränkt. Das Reifenmodell muß allerdings den aufgezeigten prinzipiellen Reibwertverlauf in Abhängigkeit des Schlupfes und einen sich im Realfall einstellenden Schlupf mit einer den jeweiligen Anforderungen entsprechenden Genauigkeit berücksichtigen. Mit Hilfe der Reifenaufstandskraft ist es dann möglich, die vom Reifen unter bestimmten Bedingungen auf die Fahrbahn aufgebrachte Kraft und einen entsprechenden Sollwert für das Drehmoment der den Reifen simulierenden elektrischen Maschine zu bestimmen und damit den Reifen realitätsnah zu simulieren. Es stellt sich dann automatisch im das Drehmoment der elektrischen Belastungsmaschine nachstellenden Regelkreis für jede Drehzahl die unter diesen Bedingungen auftretende bleibende Abweichung der nominellen und Ist-Drehzahl des Rades d.h. ein bleibender Schlupf ein.

In Germann, St. (1997), "Modellbildung und Modellgestützte Regelung der Fahrzeuglängsdynamik", VDI-Bericht 12/309, findet sich auf den Seiten 34 ff. und 55 ff. eine Zusammenstellung beispielhafter Formalismen zur Berücksichtigung des Systems Reifen-Fahrbahn. Auch sind die Fundstellen für verschiedene empirische und theoretische Reifenmodelle aufgeführt und verschiedene Modellansätze verglichen. Daneben finden sich beispielhafte Gleichungen zur Berücksichtigung der Fahrzeuglängs-, Quer- und Vertikalbewegungen. Zum Modellansatz von Pacejka sind die Werte von speziellen Parametern dieses Modells abgeschätzt worden und mit theoretisch nach dem Modellansatz ermittelten Parametern verglichen worden. Der Reifenmodellansatz von Pacejka ist jedoch nur in möglicher Ansatz, der im erfindungsgemäßen Verfahren herangezogen werden kann. Der Fachmann kann das von ihm bevorzugte Reifenmodell im übrigen auch so modifizieren und gegebenenfalls vereinfachen, daß es nur solche Parameter berücksichtigt, die bei der Simulation auch berücksichtigt werden sollen. Ferner wird insbesondere für die Einbeziehung der auf den Reifen wirkenden Querkräfte und eines resultierenden Querschlupfes verwiesen auf M. Würtenberger (1997), "Modellgestützte Verfahren zur Überwachung des Fahrzustands eines PKW", VDI-Bericht 12/314, speziell Seite 30 bis 41 und Seite 156 bis 158. Auch hier ist auf das Pacejka Modell Bezug genommen.

Ein weiterer Vorteil der erfindungsgemäßen Erzeugung des Drehmomentsollwerts aus einem den Schlupf einbeziehenden Reifenmodell besteht darin, daß die Verzögerung der Momentänderung entsprechend der Latsch-Verschiebung, des veränderlichen Anteils der Radlauffläche mit Kontakt zur Straße, durch das Reifenmodell simuliert werden kann.

Hierbei kann auch der durch die Abplattung der Reifenaufstandsfläche sich jeweils einstellende dynamische Reifenradius berücksichtigt werden. Die erfindungsgemäß be - stimmte, von den Reifen im Realfall auf die Fahrbahn übertragene Kraft wird in ein ge - speichertes Fahrzeugmodell eingegeben, um die dem Reifenmodell zugeführte Fahrzeuggeschwindigkeit zu ermitteln. Vorzugsweise wird hierzu im Fahrzeugmodell die vom Fahrzeuggeschwindigkeitswert abhängige Fahrzeugwiderstandskraft berechnet und von dieser die von den jeweils betrachteten Rädern auf die Fahrbahn übertragenen Kräfte subtrahiert und aus der resultierenden Differenz und der Masse des Fahrzeugs der Fahrzeuggeschwindigkeitswert ermittelt.

Die Reifenaufstandskraft kann im die Fahrzeugdynamik berücksichtigenden Fahrzeugmodell für jeden Reifen abhängig von der Fahrsituation ermittelt werden, so daß die Schlupfsimulation für jeden Reifen möglich ist, ohne die Momentenverteilung vorab zu kennen oder abschätzen zu müssen. Eine realistische Momentenverteilung stellt sich vielmehr durch diese Art der erfindungsgemäßen Schlupfsimulation von selbst ein.

Ein besonderer Vorteil des erfindungsgemäßen Verfahrens besteht darin, daß im Reifenmodell nicht nur die Abhängigkeit der Eigenschaften des schlupfenden Rades von Last und Raddrehzahl sowie der Fahrzeuggeschwindigkeit nachgebildet werden können, sondern auch vom Schräglaufwinkel des Rades bzw. Reifens. Der Schräglaufwinkel ist der Winkel zwischen dem Vektor der Radgeschwindigkeit und der Radlängsachse (wie auf Seite 34 des oben zitierten VDI-Berichts von Würtemberger angegeben.) So wird bei dieser Weiterbildung des erfindungsgemäßen Verfahrens die Fahrzeuggeschwindigkeit als Vektor in das Reifenmodell eingegeben, das zusätzlich zu einer Längs- oder Umfangskraft des Reifens auch eine Quer- oder Seitenkraft des Reifens ermittelt. Der resultierende Kraftvektor wird in das Fahrzeugmodell zurückgeführt, das unter Berücksichtigung dieses Kraftvektors den translatorischen Geschwindigkeitsvektor des Rades ermittelt. Hierdurch können auf das Fahrzeug und jeden einzelnen Reifen wirkende Querkräfte berücksichtigt werden.

Dem Fahrzeugmodell wird zur Berücksichtigung der Querkräfte auch der Lenkradwinkel zugeführt. Der sich für jedes Rad einstellende Schräglaufwinkel wird dann im Fahrzeugmodell aus dem Lenkradwinkel bzw. dem hieraus resultierenden Radeinschlagwinkel ermittelt und in das Reifenmodell eingegeben.

Ein Vorteil ergibt sich auch, wenn die Rollwiderstandskraft in Abhängigkeit von der Reifenaufstandskraft und der Raddrehzahl im Reifenmodell für jeden Reifen ermittelt und bei der vom jeweiligen Reifen auf die Fahrbahn übertragenen Kraft berücksichtigt wird. Bisher hat man ein dem Rollwiderstand entsprechendes Moment pauschal aus der Fahrzeuggeschwindigkeit bestimmt und in einem Gesamt-Fahrzeugwiderstandsmoment berücksichtigt.

Bevorzugt werden die Reifenparameter für das Reifenmodell in Form von Modellkonstanten für die Beziehung zwischen Schlupf und Reibwert, dem Reifenradius, einem Reifenkennfeld für die vom Reifen auf die Fahrbahn übertragene Längskraft und für das Reifenrückstellmoment und vorzugsweise auch einem Reifenkennfeld für die vom Reifen auf die Fahrbahn übertragene Querkraft gespeichert.

Außer der vom Reifen auf die Fahrbahn aufgebrachten Kraft und dem Solldrehmoment können vom Reifenmodell bedarfsweise auch der Schlupfwert und der sich abhängig von den auf den Reifen einwirkenden Kräften (bedingt durch Aufstandskraft, Luftdruck, Drehzahl usw.) ändernde dynamische Radradius r_{dyn} ausgegeben werden.

Somit ist es mit dem erfindungsgemäßen Verfahren nicht nur möglich, verschiedene Antriebssysteme zu analysieren, sondern auch unterschiedlichste Fahrbahnbeläge und Straßenzustände in variierenden Fahrsituationen zu berücksichtigen. Darüber hinaus können Streckenprofile unabhängig von Prüfling und Straßenzustand aufgenommen werden. So können beispielsweise mit GPS (Global Position System) aufgenommene Streckendaten in den Simulationsrechner eingegeben werden und mit beliebigen ebenfalls eingegebenen Fahrzeug- und Reifendaten kombiniert werden. Damit können am Prüfstand Kombinationen von unterschiedlichen Prüflingen und Strecken simuliert werden. Dies stellt einen entscheidenden Vorteil gegenüber der bisherigen Praxis des Abfahrens einer Strecke mit realen Fahrzeugen unter Aufnahme der Lastkollektive und des Nachfahrens dieser Lastkollektive auf einem Prüfstand dar. Somit können erfindungsgemäß Prüflinge getestet werden, für die es noch kein Fahrzeug und keine aufgenommenen Lastkollektive gibt. Auch können die Fahrbahneigenschaften (z.B. trockene oder nasse Oberflächen) in der Simulation beliebig abgeändert werden.

Ferner ermöglicht das erfindungsgemäße Verfahren, jeden einzelnen Reifen auch hinsichtlich Reifenaufstandskraft und Rollwiderstand individuell zu berücksichtigen.

Im Bedarfsfall kann das Fahrzeugmodell auch den Schwimmwinkel liefern.

Im folgenden wird die Erfindung anhand der Zeichnungen näher erläutert. Es zeigen
Figur 1 eine Prinzipdarstellung eines auf einem Fahrbahnabschnitt rollenden Reifens,
Figur 2 gemessene stationäre Kennfelder für Längs-, Querkraft und Rückstellmoment als Funktion des Reifenschlupfes eines Reifens und
Figur 3 ein Blockschaltbild zur Verdeutlichung des erfindungsgemäßen Verfahrens.

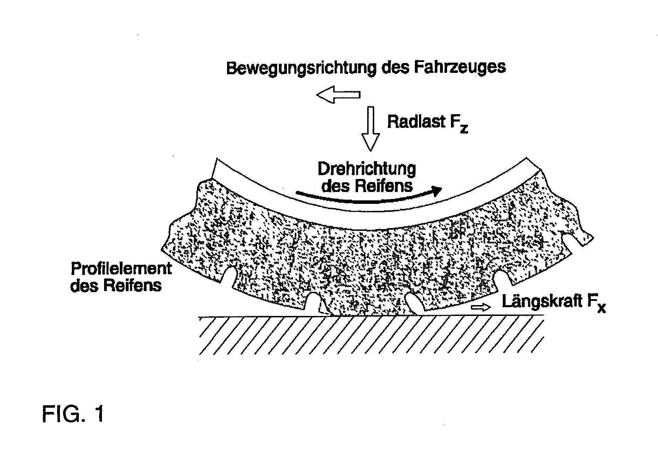

In Figur 1 ist der einfachere Fall dargestellt, daß durch den Reifen nur eine Längskraft Fₓ und nicht auch eine Querkraft auf die Fahrbahn übertragen wird. Bekanntermaßen tritt bedingt durch die Gummireibung des Reifens auf der Fahrbahn ein Schlupf in Form einer Relativbewegung zwischen Reifen und Fahrbahnoberfläche auf. Die Radaufstandskraft F_{z} und die Längskraft Fₓ sind über den Reibwert µ miteinander verknüpft. Dieser ist jedoch nicht konstant, sondern schlupfabhängig. Diese Abhängigkeit vom Schlupf λ wird erfindungsgemäß unter Heranziehen eines der weiter oben aufgezeigten Reifenmodelle nachgebildet.

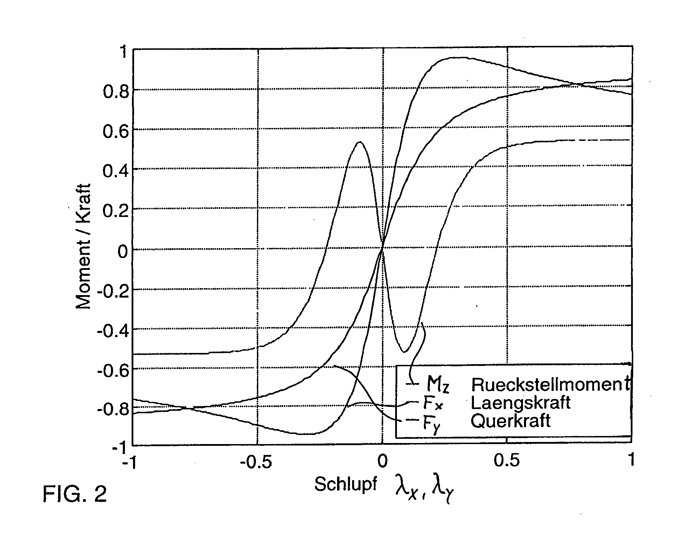

Die Figur 2 zeigt neben dem Verlauf der Längs- oder Umfangskraft Fₓ als Ausgangsgröße eines statischen Reifenmodells auch die Quer- oder Seitenkraft Fy sowie das Rückstellmoment als Funktion des Schlupfes λ. Die gezeigten Verläufe sind unter der Annahme reiner Längsbewegung (Querkraft null) oder reiner Querbewegung (Längskraft null) aufgetragen. Die aufgetragenen Werte wurden auf einem Trommelprüfstand für einen kommerziell erhältlichen PKW-Reifen bei konstanter Aufstandskraft (auch Radlast) und Sturz von null sowie konstanter Geschwindigkeit aufgenommen. Der als Eingangsgröße des Reifenmodells aus den Fahrzeuggrößen berechnete Schlupf stellt eine vektorielle Größe dar mit einer Schlupfkomponente λₓ in Radlängsrichtung und einer Schlupfkomponente λ_{y} in Radquerrichtung.

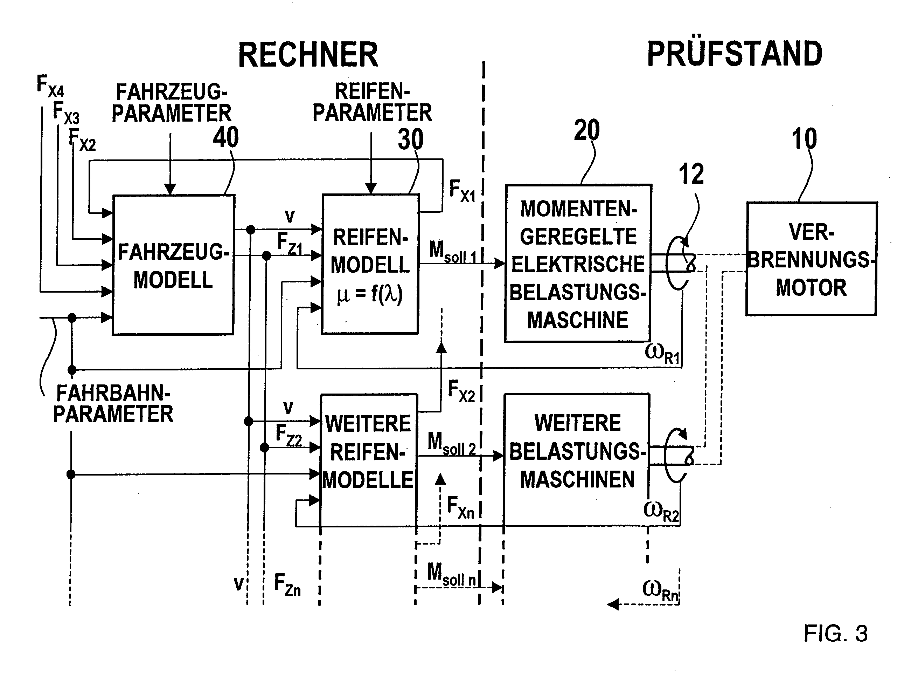

Der Übersichtlichkeit halber berücksichtigt die Figur 3 keine Querkräfte. Links von der gestrichelten Linie im Blockschaltbild der Figur 3 sind die Funktionsblöcke des Simulationsrechners dargestellt, rechts von der Linie die Elemente des Prüfstands angedeutet. Dabei repräsentiert diese schematische Darstellung eine Antriebswelle eines Antriebstrangprüfstandes, die anderen sind lediglich angedeutet. Auf diese Antriebswelle wirkt ein Verbrennungsmotor 10. Eine drehmomentgeregelte elektrische Belastungsmaschine 20 ist an der vom Motor 10 angetriebenen Welle 12 in an sich bekannter Weise angebracht. Vorzugsweise entspricht die Trägheit dieser Maschine in etwa der eines Rades, so daß durch die Maschine die Drehbewegung des Rades als dynamisches System real nachgebildet wird und nicht simuliert zu werden braucht. Die Belastungsmaschine 20 und deren nicht dargestellte Drehmomentregelung sind so ausgelegt, daß das abgegebene Maschinenmoment schnellstmöglich auf den jeweiligen, vom Simulationsrechner bestimmten Drehmomentsollwert gebracht wird.

Die Drehzahl an der Antriebswelle 12, die die Ausgangsdrehzahl der Belastungsmaschine 20 und des durch diese simulierten Rades darstellt, wird zeitlich hochaufgelöst für praktisch jede durch Winkel und Phase definierte Drehposition von einem nicht dargestellten Drehzahlsensor gemessen und als Radwinkelgeschwindigkeit ω_{R1} dem Simulationsrechner zugeführt und in das in diesem gespeicherte Reifenmodell 30 eingegeben. In das Reifenmodell fließen ferner die jeweils einen Reifentyp kennzeichnenden Reifenparameter ein. Diese Reifenparameter können in Form von Konstanten für die jeweilige Reibwertschlupfkurve und/ oder in Form der weiter oben erwähnten Reifenkennfelder im Rechner gespeichert sein. Die vorzugsweise streckenabhängigen Fahrbahnparameter stellen eine weitere Eingangsgröße in das Reifenmodell 30 dar. Aus einem die Fahrzeugdynamik berücksichtigenden Fahrzeugmodell 40 werden dem Reifenmodell 30 die Fahrzeuggeschwindigkeit v und die Reifenaufstandskraft F_{Z1} zugeführt. Das Reifenmodell liefert als Ausgangsgrößen den Drehmomentsollwert M_{Soll1} und die vom Reifen auf die Fahrbahn übertragene Längskraft F_{X1}. Die Längskraft F_{X1} wird wie auch die Längskräfte der übrigen berücksichtigten Räder zur Berechnung der Fahrzeuggeschwindigkeit v in das Fahrzeugmodell 40 rückgeführt. Bei einer bevorzugten Ausführungsform wird die Fahrzeuggeschwindigkeit v dadurch berechnet, daß die Differenz zwischen der Summe der rückgeführten Längskräfte F_{Xi} und einer ermittelten Fahrzeugwiderstandskraft mit einer der Masse des Fahrzeugs entsprechenden Zeitkonstante integriert wird. Die Fahrzeugwiderstandskraft berücksichtigt beispielsweise die Fahrbahnsteigung, den Fahrzeugluftwiderstand und einen zur Fahrzeuggeschwindigkeit proportionalen Rollwiderstand. Letzterer kann jedoch auch im Reifenmodell berücksichtigt werden, wie weiter oben bereits dargelegt wurde.

Bei Berücksichtigung der oben aufgezeigten Querkraftkomponente und der resultierenden Schlupfkomponente λ_{y} in Radquerrichtung werden Querkraft, Längskraft und Rückstellmoment im Reifenmodell vorzugsweise aus dreidimensionalen Kennfeldern entnommen, in denen diese Größen zur Simulation des dynamischen Reifenverhaltens verknüpft sind. Beispiele für derartige Kennfelder sowie auch die entsprechenden Verknüpfungsformeln sind der oben genannten Schrift von M. Würtenberger entnehmbar. Als in das Fahrzeugmodell rückgeführte Ausgangsgrößen des Reifenmodells ergeben sich dann Längskraft Fₓ und Querkraft Fy sowie das Rückstellmoment. Die Reibwerte µₓ und µ_{y} sind Terme, in denen beide Schlupfkomponenten λ_{y} und λₓ auftreten. Daher schlägt sich im aus Fₓ(µₓ) und r_{dyn} berechneten Drehmomentsollwert die Querkraft F_{y} nieder. Über die Rückführung beider Kraftkomponenten Fₓ und F_{y} in das Fahrzeugmodell wird der Einfluß des dynamischen Reifenverhaltens des betrachteten Reifens auf die anderen Reifen im Gesamtregelkreis berücksichtigt. Hiermit wird es möglich, ein echtes Vierradmodell zu simulieren. Das Fahrzeugmodell errechnet dann die Fahrzeuggeschwindigkeit v als Vektor, wobei zumindest die x- und y-Komponente in das Reifenmodell eingegeben werden. Die vom Fahrzeugmodell ausgegebene Aufstandkraft F_{z} für die einzelnen Reifen ändert sich in Abhängigkeit der Reifenquerkräfte.

Für die Reifen können unterschiedliche Reifenmodelle verwendet werden. Vorzugsweise wird immer ein ganzes Fahrzeug mit den vier Reifenmodellen simuliert, auch wenn z.B. nur eine Antriebsseite, beispielsweise der Heckantrieb, aufgebaut ist und nicht jeder Reifen "vorhanden" ist.

Das Fahrzeugmodell kann im übrigen entsprechend der obigen Schriften und der darin zitierten umfangreichen Literatur unter Berücksichtigung von auf das Fahrzeug einwirkenden Gravitations- und aerodynamischen Kräfte beliebig wirklichkeitsnah gestaltet werden, um z.B. auch die Einwirkung des Nick- und Wankverhaltens auf die Radaufstandskraft, Fahrbahnsteigung, Gegenwind und eine Fahrbahnquerneigung zu berücksichten. Die Umrechnung der einzelnen Koordinatensysteme vom äußeren Inertialsystem bis zum Radsystem kann im Fahrzeugmodell erfolgen.

Der Simulationsrechner und auch die vorgesehene Drehmomentregelung der Belastungsmaschinen arbeiten als Radschlupfsimulationsregelkreis so schnell, daß der steile Anstieg der schlupfabhängigen Reibwertkurve möglichst realitätsnah nachgefahren werden kann. Zu diesem Zweck werden die Rechenfrequenz des Modells und die Momentenanregelzeit optimiert. Eine harte Ankopplung wird durch hohe Kreisverstärkung, kleine Totzeit, kurze Abtastzeit und hohe Abtastgeschwindigkeit des Regelkreises erzielt. In einer Implementierung der Erfindung wurde mit einer Verstärkung von 200 Nm/rads, einer Totzeit von 0,6 ms und einer Abtastrate von 3 kHz gearbeitet. Die Zykluszeit für die Vorgabe eines Drehmomentsollwerts liegt vorzugsweise unter einer Millisekunde. Die Abtast- und Auswertezeitpunkte des Regelkreises werden vorzugsweise mit den sich aus der Bauart der elektrischen Belastungsmaschinen ergebenden optimalen Ansteuerzeitpunkten synchronisiert. Im übrigen werden aus der Regelungstechnik bekannte Maßnahmen wie Abtast- und Totzeitglieder mit definierter Verzögerungszeit, Rampen zur Begrenzung der maximalen Änderungsgeschwindigkeit, Dämpfungsglieder und dergleichen eingesetzt. Die Anbindung der Hardware- und Softwarekomponenten des Regelkreises an den Prüfstand erfolgt über schnelle Datenschnittstellen.

## Patentansprüche

1. Verfahren zum Simulieren des Verhaltens eines Fahrzeugs auf einer Fahrbahn an einem Antriebsstrang-Prüfstand mit Hilfe von an den Wellen des Antriebsstrangs des Fahrzeugs anbringbaren momentengeregelten, elektrischen Belastungsmaschinen und einem Rechner mit einem darin gespeicherten Fahrzeugmodell und einem die schlupfabhängige Reibung nachbildenden Reifenmodell, in welchem Verfahren an wenigstens einer der Wellen die Raddrehzahl gemessen wird, aus der das Reifenmodell unter Heranziehung einer Fahrzeuggeschwindigkeit und einer Reifenaufstandskraft eine vom Reifen bei dieser Raddrehzahl auf die Fahrbahn übertragene Kraft und ein sich für diese Kraft ergebendes Solldrehmoment für die an dieser Welle angebrachte momentengeregelten Belastungsmaschine derart bestimmt, daß sich zwischen einem nominellen Drehzahlwert, der der dem Reifenmodell zugeführten Fahrzeuggeschwindigkeit entspricht, welche unter Rückführung der auf die Fahrbahn übertragenen Kraft im Fahrzeugmodell berechnet wird, und der gemessenen Raddrehzahl eine dem real auftretenden Schlupf entsprechende Differenz einregelt.

2. Verfahren nach Anspruch 1, in welchem in das Reifenmodell die Parameter eines nachzubildenden Reifens und die Parameter der Fahrbahn eingegeben werden.

3. Verfahren nach Anspruch 1 oder 2, in welchem im Fahrzeugmodell des Rechners die von der Fahrzeuggeschwindigkeit abhängige Fahrzeugwiderstandskraft berechnet wird und von dieser die von den jeweils betrachteten Rädern auf die Fahrbahn übertragenen Kräfte subtrahiert werden und aus der resultierenden Differenz und der Masse des Fahrzeugs die Fahrzeuggeschwindigkeit ermittelt wird.

4. Verfahren nach einem der vorhergehenden Ansprüche, in welchem im Fahrzeugmodell der für einen Lenkradwinkel resultierende Radeinschlagwinkel ermittelt wird und der sich entsprechend einstellende Schräglaufwinkel des Rades bzw. Reifens zur Berechnung eines Quer- und Längsschlupfes des Reifens im Reifenmodell herangezogen wird, woraus sich wiederum eine Quer- und Längskraft und ein Rückstellmoment des Reifens ermitteln lassen, die in das Fahrfahrzeugmodell zurückgeführt werden.

5. Verfahren nach einem der vorhergehenden Ansprüche, in welchem die Reifenaufstandskraft aus dem die Fahrzeugdynamik berücksichtigenden Fahrzeugmodell ermittelt wird.

6. Verfahren nach einem der vorhergehenden Ansprüche, in weichem im Reifenmodell des Rechners die Rollwiderstandskraft in Abhängigkeit von der Reifenaufstandskraft und der Raddrehzahl berechnet wird und bei der Ermittlung der vom jeweiligen Reifen auf die Fahrbahn übertragenen Kraft berücksichtigt wird.

7. Verfahren nach einem der vorhergehenden Ansprüche, in welchem als Reifenparameter für das Reifenmodell außer den Konstanten für die Schlupfdynamik und zugehörige Dämpfung sowie dem Reifenradius ein Kennfeld für die auf die Fahrbahn übertragene Längskraft und vorzugsweise auch ein Kennfeld für die vom Reifen auf die Fahrbahn aufgebrachte Querkraft und ein Kennfeld für das Reifenrückstellmoment gespeichert werden.

8. Verfahren nach einem der vorhergehenden Ansprüche, in welchem in den Rechner der Schräglauf und das Bremsmoment zur Berücksichtigung im Reifenmodell und im Fahrzeugmodell eingegeben werden.

9. Verfahren nach einem der vorhergehenden Ansprüche, in welchem als elektrische Belastungsmaschinen solche eingesetzt werden, die das jeweilige Radträgheitsmoment nachbilden.

## Claims

1. Procedure for simulating the behaviour of a vehicle on a roadway on a drive train test stand with the aid of controlled-torque electric loading machines that can be fitted to the shafts of the drive train of the vehicle, and a computer having a vehicle model stored therein and a tyre model simulating the slip-dependent friction, in which procedure the wheel rotational speed is measured on at least one of the shafts, a force transmitted to the roadway by the tyre at this wheel rotational speed and a reference torque resulting for this force for the controlled-torque loading machine fitted to this shaft being determined from the tyre model by using a vehicle speed and a tyre contact force in such a way that, between a nominal rotational speed value which corresponds to the vehicle speed fed to the tyre model and which is calculated in the vehicle model while feeding back the force transmitted to the roadway, and the measured wheel rotational speed, a difference corresponding to the slip which occurs in practice is adjusted.

2. Procedure according to Claim 1, in which the parameters of a tyre to be simulated and the parameters of the roadway are entered into the tyre model.

3. Procedure according to Claim 1 or 2, in which the vehicle resistance force dependent on the vehicle speed is calculated in the vehicle model of the computer and the forces transmitted to the roadway from the wheels considered in each case are subtracted from the said vehicle resistance force and the vehicle speed is determined from the resultant difference and the mass of the vehicle.

4. Procedure according to one of the preceding claims, in which the wheel lock angle resulting for a steering wheel angle is determined in the vehicle model and the oblique running angle of the wheel and tyre accordingly established is used to calculate transverse and longitudinal slip of the tyre in the tyre model, from which, in turn, a transverse and longitudinal force and a restoring torque of the tyre can be determined, which are fed back into the vehicle model.

5. Procedure according to one of the preceding claims, in which the tyre contact force is determined from the vehicle model that takes account of the vehicle dynamics.

6. Procedure according to one of the preceding claims, in which the rolling resistance force is calculated in the tyre model of the computer as a function of the tyre contact force and the wheel rotational speed and is taken into account when determining the force transmitted from the respective tyre to the roadway.

7. Procedure according to one of the preceding claims, in which the tyre parameters that are stored for the tyre model, in addition to the constant for the slip dynamics and associated damping and also the tyre radius, are also a characteristic map for the longitudinal force transmitted to the roadway and preferably also a characteristic map for the transverse force applied to the roadway by the tyre and a characteristic map for the tyre restoring torque.

8. Procedure according to one of the preceding claims, in which the oblique running and the braking torque to be taken into account in the tyre model and in the vehicle model are entered into the computer.

9. Procedure according to one of the preceding claims, in which the electric loading machines used are those which simulate the respective wheel moment of inertia.

## Revendications

1. Procédé de simulation du comportement d'un véhicule sur une chaussée sur un banc d'essai de transmission, au moyen d'engins électriques de contrainte à régulation de couple applicables sur les arbres de transmission du véhicule et d'un calculateur contenant un modèle de véhicule mémorisé et un modèle de pneu reproduisant le frottement lié au patinage, la vitesse de rotation étant dans le cadre dudit procédé mesurée au moins sur un des arbres, à partir de laquelle le modèle de pneu détermine, par recours à une vitesse de roue et à une force de contact du pneu au sol, une force transmise par le pneu à la chaussée à ladite vitesse de roue et un couple de consigne résultant à cette force pour l'engin électrique de contrainte à régulation de couple appliqué sur l'arbre concerné, de manière à régler entre une valeur nominale de vitesse de rotation correspondant à la vitesse de véhicule appliquée au modèle de pneu, laquelle est calculée en fonction de la force transmise à la chaussée dans le modèle de véhicule, et la vitesse de roue mesurée, une différence correspondant au patinage effectif constaté.

2. Procédé selon la revendication 1, dans lequel les paramètres d'un pneu à reproduire et les paramètres de la chaussée sont entrés dans le modèle de pneu.

3. Procédé selon la revendication 1 ou 2, dans lequel la force de résistance de véhicule dépendant de la vitesse du véhicule est calculée dans le modèle de véhicule du calculateur, et les forces transmises à la chaussée par les roues prises en compte sont soustraites de celle-ci, et la vitesse du véhicule est déduite de la différence ainsi obtenue et de la masse du véhicule.

4. Procédé selon l'une des revendications précédentes, dans lequel l'angle de braquage de roue résultant d'un angle de volant de direction est déterminé dans le modèle de véhicule et l'angle d'inclinaison de l'axe pivot consécutivement réglé de la roue respectivement du pneu est utilisé pour le calcul d'un patinage transversal et longitudinal du pneu dans le modèle de pneu, à partir duquel une force transversale et longitudinale et un couple de rappel du pneu peuvent à leur tour être déterminés, lesquels seront retournés au modèle de véhicule.

5. Procédé selon l'une des revendications précédentes, dans lequel la force de contact du pneu au sol est déterminée à partir du modèle de véhicule prenant la dynamique du véhicule en compte.

6. Procédé selon l'une des revendications précédentes, dans lequel la force de résistance au roulement est calculée dans le modèle de pneu du calculateur en fonction de la force de contact du pneu au sol et de la vitesse de roue, et la force transmise à la chaussée par le pneu respectif est prise en compte pour la détermination.

7. Procédé selon l'une des revendications précédentes, dans lequel un diagramme caractéristique pour la force longitudinale transmise à la chaussée et, de préférence, également un diagramme caractéristique pour la force transversale appliquée par le pneu sur la chaussée et un diagramme caractéristique pour le couple de rappel du pneu sont mémorisés comme paramètres de pneu pour le modèle de pneu, outre les constantes pour la dynamique de patinage et pour l'amortissement correspondant, ainsi que le rayon de pneu.

8. Procédé selon l'une des revendications précédentes, dans lequel l'inclinaison de l'axe pivot et le couple de freinage sont entrés dans le calculateur pour être pris en compte dans le modèle de pneu et dans le modèle de véhicule.

9. Procédé selon l'une des revendications précédentes, dans lequel les engins électriques de contrainte mis en oeuvre sont ceux qui reproduisent le moment d'inertie de roue respectif.
